# EUROPÄISCHE PATENTSCHRIFT

(11) **EP 1 295 162 B1**
(45) Veröffentlichungstag und Bekanntmachung des Hinweises auf die Patenterteilung: **01.12.2004**
(21) Anmeldenummer: 01949211.5
(22) Anmeldetag: 11.05.2001
(51) Int. Cl.: G02B 26/08, H01L 41/09

(54) **VORRICHTUNG ZUR ABLENKUNG VON OPTISCHEN STRAHLEN**
DEVICE FOR DEFLECTING OPTICAL BEAMS
DISPOSITIF POUR DEVIER DES RAYONS OPTIQUES

(30) Priorität: 30.06.2000 DE 10031877
(43) Veröffentlichungstag der Anmeldung: 26.03.2003
(73) Patentinhaber: Fraunhofer-Gesellschaft zur Förderung der angewandten Forschung e.V., 80686 München (DE)
(72) Erfinder: HINKOV, Vladimir, 79199 Kirchzarten (DE); HINKOV, Iliyana, 79199 Kirchzarten (DE)
(74) Vertreter: RACKETTE Partnerschaft Patentanwälte
(86) Internationale Anmeldenummer: PCT/DE2001/001813
(87) Internationale Veröffentlichungsnummer: WO 2002/003120

(56) Entgegenhaltungen:
- EP-A- 0 661 874
- US-A- 4 385 798
- US-A- 4 491 761
- US-A- 4 812 698
- US-A- 5 001 681
- US-A- 5 225 731
- US-A- 5 715 337
- US-A- 5 994 821
- PATENT ABSTRACTS OF JAPAN vol. 017, no. 681 (P-1660), 14. Dezember 1993 (1993-12-14) -& JP 05 231815 A (CANON INC), 7. September 1993 (1993-09-07)
- PATENT ABSTRACTS OF JAPAN vol. 1999, no. 11, 30. September 1999 (1999-09-30) -& JP 11 167078 A (NIKON CORP), 22. Juni 1999 (1999-06-22)

## Beschreibung

Die Erfindung betrifft eine Vorrichtung zur Ablenkung von optischen Strahlen mit einem piezoelektrische Bereiche aufweisenden Piezoplättchen und mit an Oberflächen aufgebrachten Piezoelektroden zur Ansteuerung des Piezoplättchens.

Eine derartige Vorrichtung ist aus dem Artikel "Piezoelectric bimorph optical beam scanners: analysis and construction" von J. Kelly Lee, erschienen in APPLIED OPTICS Vol. 18, No. 4, Seiten 454 bis 459, bekannt. Bei der vorbekannten Vorrichtung ist an einem Piezoplättchen ein Spiegel angebracht. Bei Ansteuerung von Piezoelektroden mit einer Steuerspannung im mittleren Spannungsbereich bewegt sich aufgrund der induzierten Biegung des Piezoplättchens der Spiegel. Nachteilig bei dieser Vorrichtung ist die verhältnismäßig hohe zu bewegende Masse, die einer schnellen Ansteuerung entgegensteht.

Eine ähnliche Vorrichtung ist aus US 5 994 821 bekannt.

Der Erfindung liegt die Aufgabe zugrunde, eine Vorrichtung der eingangs genannten Art anzugeben, die sich durch eine schnelle Ansteuerbarkeit und eine verzerrungsfreie Ablenkung auszeichnet.

Diese Aufgabe wird bei einer Vorrichtung der eingangs genannten Art erfindungsgemäß dadurch gelöst, dass das Piezoplättchen nach Anspruch 1 in einem Endabschnitt frei von Piezoelektroden ist.

Dadurch, dass bei dem Piezoplättchen ein Endabschnitt frei von Piezoelektroden ist, wird in dem betreffenden Endabschnitt keine Biegung induziert, sondern der von Piezoelektroden freie Endabschnitt bleibt im wesentlichen plan. Durch eine zweckmäßigerweise relativ zu den Dimensionen der den freien Endabschnitt beaufschlagenden Strahlen größere Dimensionierung des freien Endabschnittes werden bei einer Reflexion oder Transmission des Endabschnitt die Wellenfronten und damit die Strahlcharakteristik, insbesondere die Divergenz, nicht oder nur unwesentlich gestört.

Bevorzugte Ausgestaltungen ergeben sich aus den abhängigen Patentansprüchen.

Weitere zweckmäßige Ausgestaltungen und Vorteile der Erfindung sind Gegenstand der nachfolgenden Beschreibung von bevorzugten Ausführungsbeispielen unter Bezug auf die Figuren der Zeichnung. Es zeigen:
- Fig. 1: in einer perspektivischen Ansicht ein erstes Ausführungsbeispiel der Erfindung mit einem Piezoplättchen, das zwei Piezoschichten mit gleicher Ausrichtung der spontanen Polarisation aufweist,
- Fig. 2: in einer perspektivischen Ansicht ein zweites Ausführungsbeispiel der Erfindung mit einem Piezoplättchen, das zwei Piezoschichten mit entgegengesetzter Ausrichtung der spontanen Polarisation aufweist,
- Fig. 3: in einer Seitenansicht das zweite Ausführungsbeispiel gemäß Fig. 2 bei der Ablenkung eines Lichtstrahls,
- Fig. 4: in einer perspektivischen Ansicht ein drittes nicht innerhalb des beanspruchten Schutzumfang liegendes Ausführungsbeispiel mit kapazitiven Elektroden,
- Fig. 5: in einer perspektivischen Ansicht ein viertes Ausführungsbeispiel der Erfindung mit einer internen Strahlführung,
- Fig. 6: in einer Seitenansicht ein fünftes nicht innerhalb des beanspruchten Schutzumfang liegendes Ausführungsbeispiel mit einem Piezoplättchen, das zur Halterung zwei Arme aufweist,
- Fig. 7: in einer Draufsicht das fünfte nicht innerhalb des beanspruchten Schutzumfang liegendes Ausführungsbeispiel gemäß Fig. 7,
- Fig. 8: in einer perspektivischen Ansicht ein sechstes nicht innerhalb des beanspruchten Schutzumfang liegendes Ausführungsbeispiel für eine zweidimensionale Ablenkung und
- Fig. 9: in einer Seitenansicht ein siebtes Ausführungsbeispiel der Erfindung mit alternierenden Ausrichtbereichen.

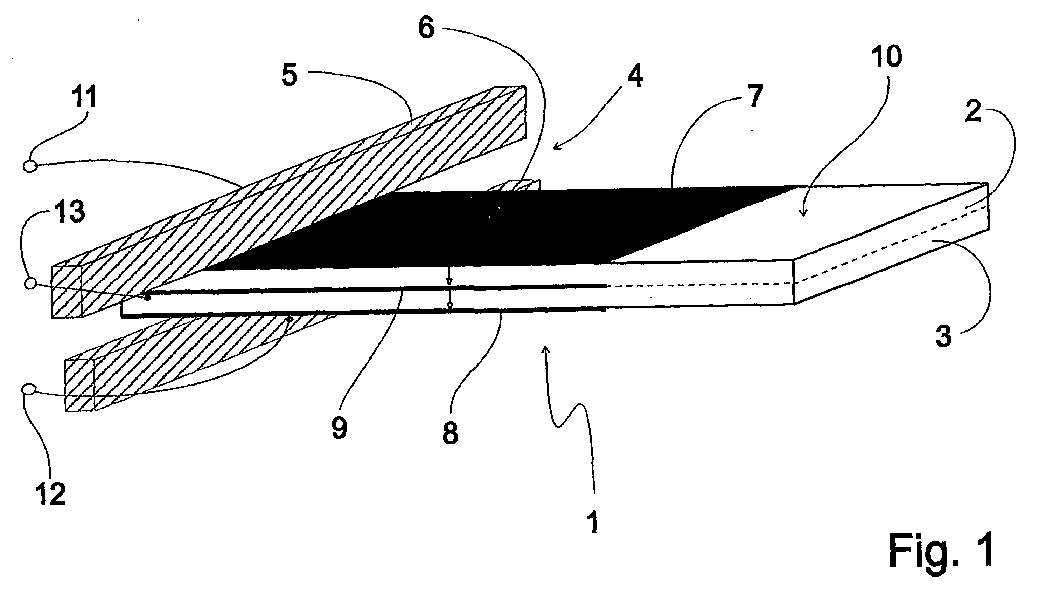

Fig. 1 zeigt in einer perspektivischen Ansicht ein erstes Ausführungsbeispiel der Erfindung. Das Ausführungsbeispiel gemäß Fig. 1 verfügt über ein flaches Piezoplättchen 1 mit rechteckiger Grundfläche, das zwei einzelne Piezoschichten 2, 3 mit gleicher Ausrichtung der spontanen Polarisation rechtwinklig zu der Ebene der Piezoschichten 2, 3 aufweist. An einer ersten schmalen Endseite ist das Piezoplättchen 1 in eine Haltereinheit 4 mit zwei Halterstegen 5, 6 eingespannt.

Jede Piezoschicht 2, 3 ist an ihrer nach außen weisenden Flachseite mit einer Außenelektrode 7, 8 als Piezoelektrode belegt. Weiterhin ist zwischen den Piezoschichten 2, 3 eine Mittelelektrode 9 als Piezoelektrode vorgesehen. Jede Außenelektrode 7, 8 und die Mittelelektrode 9 erstrecken sich von der ersten schmalen Endseite in Richtung der gegenüberliegenden zweiten schmalen Endseite, wobei ein Endabschnitt 10 der zweiten schmalen Endseite frei von den Außenelektrode 7, 8 und der Mittelelektrode 9 ist.

Jede Außenelektrode 7, 8 ist elektrisch mit einem zugeordneten Außenelektrodenanschluß 11, 12 verbunden, während die Mittelelektrode 9 elektrisch an einen Mittelelektrodenanschluß 13 angeschlossen ist. Durch Anlegen einer Spannung im mittleren Spannungsbereich zwischen den Mittelelektrodenanschluß 13 und jeden Außenelektrodenanschluß 11, 12 läßt sich das Piezoplättchen 1 im Bereich der Außenelektroden 7, 8 und der Mittelelektrode 9 bei gegengerichteter Polarität der Spannungen zu einer Biegung in Längsrichtung um die Querachse ansteuern.

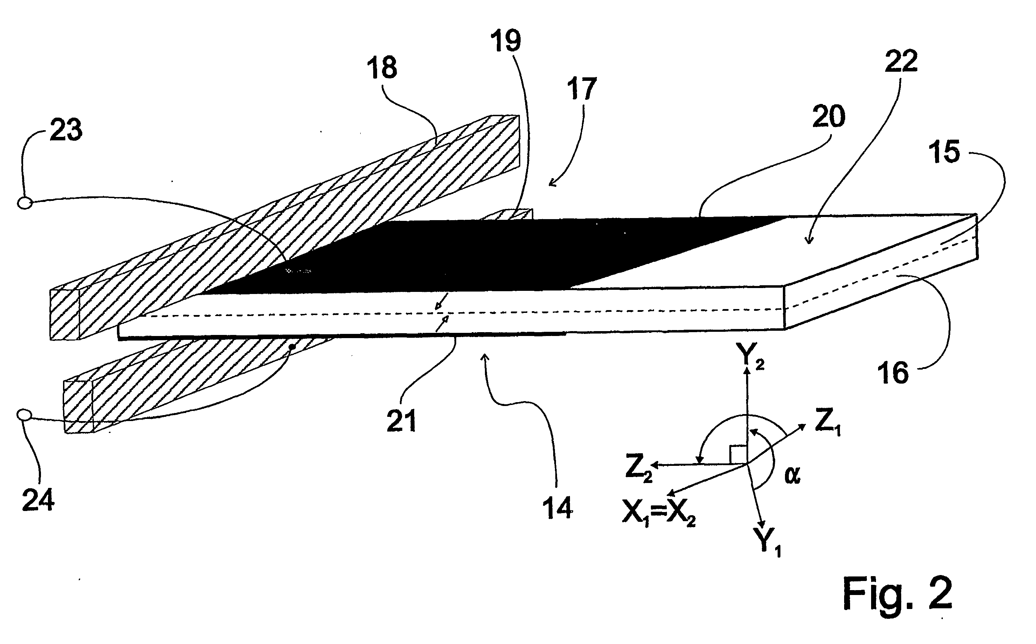

Fig. 2 zeigt in einer perspektivischen Ansicht ein zweites Ausführungsbeispiel der Erfindung. Bei den nachfolgenden Erläuterungen beziehen sich mit "1" indizierte Angaben auf das Kristallkoordinatensystem und mit "2" indizierte Angaben auf das Koordinatensystem des Piezoplättchens. Bei dem Ausführungsbeispiel gemäß Fig. 2 ist ein flaches, kristallines Y₂-Schnitt-Piezoplättchen 14 mit rechteckiger Grundfläche vorgesehen, das zwei Piezoschichten 15, 16 mit entgegengesetzter Ausrichtung der spontanen Polarisation in der Ebene der Piezoschichten 15, 16 aufweist. Die Piezoschichten 15, 16 sind beispielsweise durch Erhitzung zur lokalen Domäninversion hergestellt. Die Z₂-Achsen des kartesischen Koordinatensystems des Piezokristalls sind parallel zu der Längsseite des Piezoplättchens 14 ausgerichtet, während die Y₂-Achse des Piezoplättchens 14 gegenüber der Y₁-Kristallachse um einen Winkel von typischerweise etwa 120 Grad bis etwa 160 Grad mit den zusammenfallenden X₁- und X₂-Achsen als Drehachse gedreht ist. Entsprechend dem anhand Fig. 1 erläuterten ersten Ausführungsbeispiel ist das Piezoplättchen 14 mit einer ersten schmalen Endseite in eine Haltereinheit 17 mit zwei Halterstegen 18, 19 eingespannt.

Jede Piezoschicht 15, 16 des Piezoplättchens 14 gemäß dem zweiten Ausführungsbeispiel ist an ihrer nach außen weisenden Flachseite mit einer Außenelektrode 20, 21 als Piezoelektrode belegt. Jede Außenelektrode 20, 21 erstreckt sich von der ersten schmalen Endseite in Richtung der gegenüberliegenden zweiten schmalen Endseite, wobei ein Endabschnitt 22 der zweiten schmalen Endseite frei von Außenelektroden 20, 21 verbleibt.

Jede Außenelektrode 20, 21 ist elektrisch mit einem zugeordneten Außenelektrodenanschluß 23, 24 verbunden. Durch Anlegen einer Spannung im mittleren Spannungsbereich zwischen die Außenelektrodenanschlüsse 23, 24 läßt sich das Piezoplättchen 14 im Bereich der Außenelektroden 20, 21 zu einer Biegung in Längsrichtung um die Querachse ansteuern.

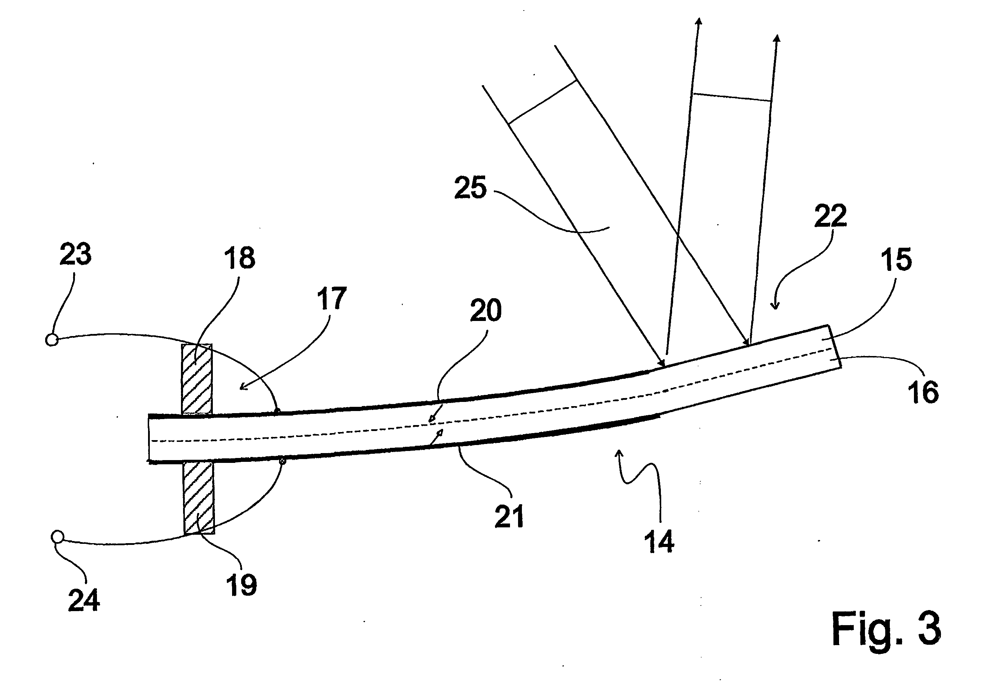

Fig. 3 zeigt in einer Seitenansicht das zweite Ausführungsbeispiel gemäß Fig. 2 bei der Ablenkung eines Lichtstrahls 25, der beispielsweise mit einer ebenen Wellenfront auf den von Außenelektroden 20, 21 freien Endabschnitt 22 fällt. Bei Anlegen einer Spannung zwischen die Außenelektrodenanschlüsse 23, 24 biegt sich das Piezoplättchen 14 lediglich im Bereich der Außenelektroden 20, 21, während der von dem Lichtstrahl 25 beaufschlagte Endabschnitt 22 bis auf einen verhältnismäßig schmalen Übergangsbereich zu den Außenelektroden 20, 21 plan verbleibt. Dadurch ergibt sich ein Reflexionsverhalten entsprechend einem Planspiegel, und die reflektierte Wellenfront wird gegenüber der einfallenden Wellenfront nicht deformiert.

Ein entsprechendes Biegungsverhalten weist das Piezoplättchen 1 gemäß dem ersten Ausführungsbeispiel nach Fig. 1 auf.

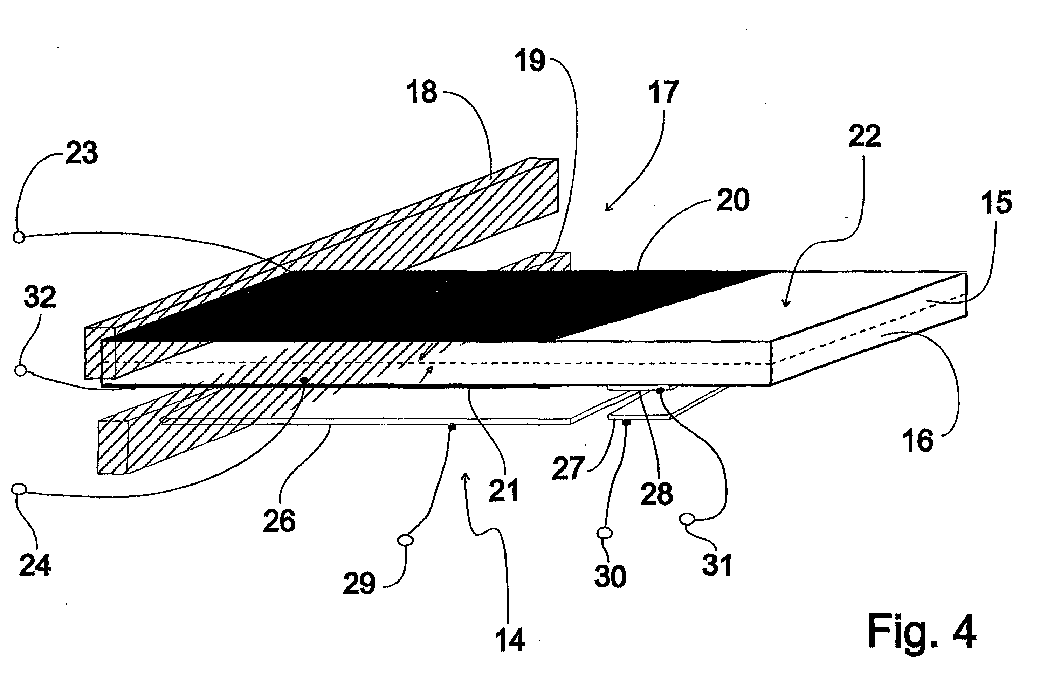

Fig. 4 zeigt in einer perspektivischen Ansicht ein drittes nicht innerhalb des beanspruchten Schutzumfang liegendes Ausführungsbeispiel, welches als Weiterbildung des anhand Fig. 2 und Fig. 3 erläuterten zweiten Ausführungsbeispiels dargestellt ist. Es versteht sich, dass die weiterbildenden Merkmale ebenfalls in Verbindung mit dem anhand Fig. 1 erläuterten ersten Ausführungsbeispiel vorgesehen sein können. Bei dem dritten Ausführungsbeispiel gemäß Fig. 4 sind eine flächige erste Gegenelektrode 26, eine längliche zweite Gegenelektrode 27 sowie eine längliche Zusatzelektrode 28 vorgesehen. Die erste Gegenelektrode 26 ist einer Außenelektrode 20, 21 gegenüberliegend angeordnet. Die Zusatzelektrode 28 ist auf einer Außenfläche einer Piezoschicht 15, 16 beispielsweise in etwa in der Mitte des Endabschnittes 22 vorgesehen und erstreckt sich in Querrichtung des Piezoplättchens 14. Die zweite Gegenelektrode 27 liegt der Zusatzelektrode 28 gegenüber. Die jeweils einander gegenüberliegenden Außenelektroden 20, 21 und erste Gegenelektrode 26 beziehungsweise die Zusatzelektrode 28 und die zweite Gegenelektrode 27 bilden kapazitiv wirkende Elektroden.

Die Gegenelektroden 26, 27 sind elektrisch mit einem ersten Gegenelektrodenanschluß 29 beziehungsweise einem zweiten Gegenelektrodenanschluß 30 verbunden. Die Zusatzelektrode 28 ist elektrisch an einen Zusatzelektrodenanschluß 31 angeschlossen, während die der ersten Gegenelektrode 26 gegenüberliegende Außenelektrode 21 weiterhin mit einem Außenelektrodenzusatzanschluß 32 verbunden ist.

Durch Anlegen einer Spannung typischerweise im mittleren Spannungsbereich an den ersten Gegenelektrodenanschluß 29 und den Außenelektrodenzusatzanschluß 32 sowie an den zweiten Gegenelektrodenanschluß 30 und den Zusatzelektrodenanschluß 31 werden zwischen der jeweiligen Außenelektrode 21 und der ersten Gegenelektrode 26 beziehungsweise zwischen der Zusatzelektrode 28 und der zweiten Gegenelektrode 27 in Abhängigkeit der Polarität der jeweiligen Spannung Kräfte auf das Piezoplättchen 14 ausgeübt, die sich mit den piezoelektrisch ausgeübten Kräften überlagern und insbesondere bei entsprechender Polung zu einer Vergrößerungen der Auslenkung führen.

Bei Abwandlungen des anhand Fig. 4 erläuterten dritten Ausführungsbeispiels ist lediglich ein Paar von einander gegenüberliegenden Außenelektroden 21 und erster Gegenelektrode 26 beziehungsweise Zusatzelektrode 28 und zweiter Gegenelektrode 27 vorgesehen.

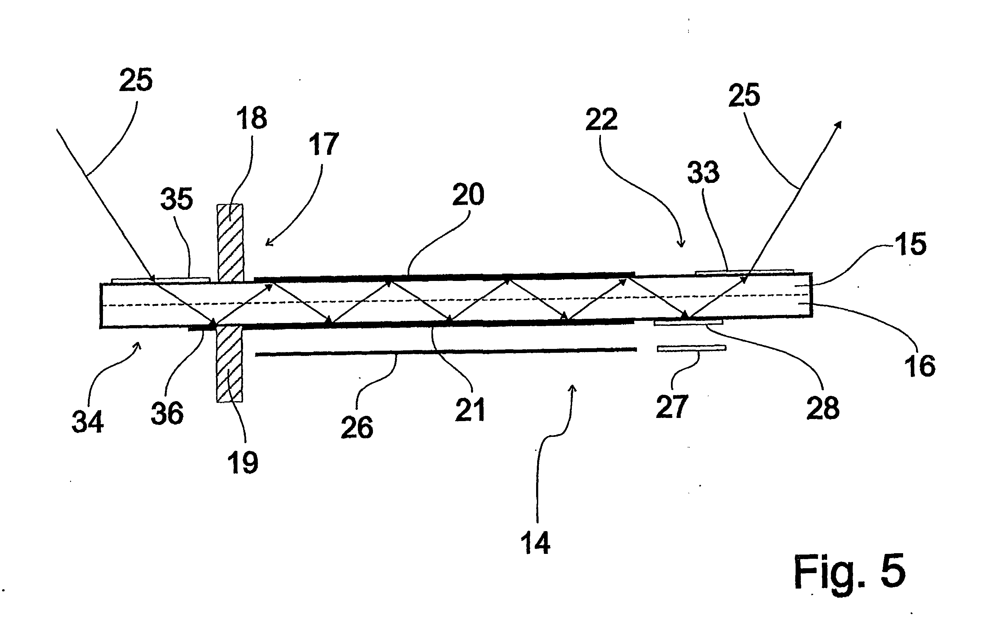

Fig. 5 zeigt in einer perspektivischen Ansicht ein viertes Ausführungsbeispiel der Erfindung, das in einigen, mit den gleichen Bezugszeichen versehenen und nachfolgend nicht näher erläuterten Merkmalen entsprechend dem anhand Fig. 4 erläuterten dritten Ausführungsbeispiel aufgebaut ist. Das vierte Ausführungsbeispiel gemäß Fig. 5 verfügt über hochreflektive Außenelektroden 20, 21. In dem von Außenelektroden 20, 21 freien Endabschnitt 22 ist eine Auskoppelentspiegelung 33 aufgebracht. Weiterhin steht das Piezoplättchen 14 mit einem Einkoppelabschnitt 34 über die Haltereinheit 17 über. Der Einkoppelabschnitt 34 ist mit einer Einkoppelentspiegelung 35 und einer Reflexionsbeschichtung 36 versehen, mit denen ein Lichtstrahl 25 in das Piezoplättchen 14 einkoppelbar ist. Nach mehrfachen Reflexionen an den Außenelektroden 20, 21 tritt der Lichtstrahl 25 über die Auskoppelentspiegelung 33 in dem von Außenelektroden 20, 21 freien Endabschnitt 22 deformationsfrei wieder aus dem Piezoplättchen 14 aus. Die Austrittsrichtung hängt dabei von der elektrischen Ansteuerung und der damit verknüpften Biegung des Piezoplättchens 14 in Längsrichtung um die Querachse ab.

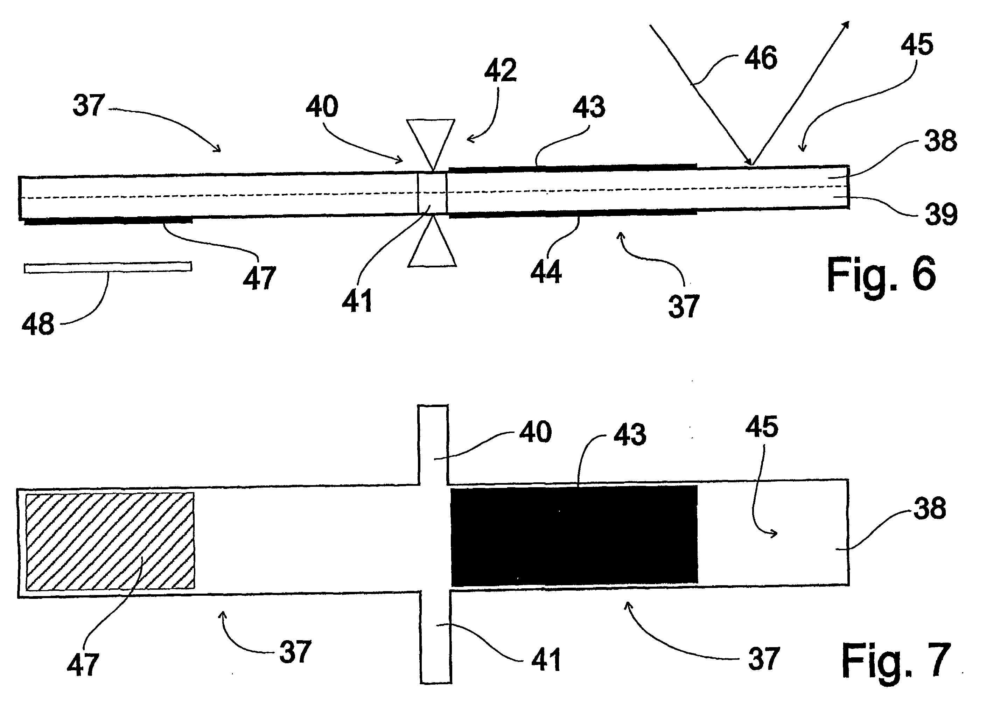

Fig. 6 und Fig. 7 zeigen in einer Seitenansicht beziehungsweise in einer Draufsicht ein fünftes nicht innerhalb des beanspruchten Schutzumfang liegendes Ausführungsbeispiel mit einem Piezoplättchen 37, das von seinem piezoelektrischen Aufbau entsprechend dem anhand Fig. 2 erläuterten Piezoplättchen 14 mit zwei Piezoschichten 38, 39 mit gegengerichteter spontaner Polarisation in der Ebene der Piezoschichten 38, 39 ausgestaltet ist. Das Piezoplättchen 37 ist im Mittenbereich mit zwei nach außen abstehenden Armen 40, 41 ausgebildet. Die Arme 40, 41 stehen mit einer Kipphalterung 42 in Eingriff, mit der das Piezoplättchen 37 schwenkbar gelagert wird.

Auf der einen Seite des Piezoplättchens 37 sind entsprechend den vorangehend erläuterten Ausführungsbeispielen Außenelektroden 43, 44 als Piezoelektroden aufgebracht, die sich von der Kipphalterung 42 bis in einen von Außenelektroden 43, 44 freien Endbereich 45 zur/deformationsfreien, in der Reflexionsrichtung steuerbaren Reflexion eines Strahls 46 erstrecken.

Auf der anderen Seite des Piezoplättchens 37 sind im Endabschnitt einander gegenüberliegend eine Zusatzelektrode 47 und eine Gegenelektrode 48 angeordnet, die mit einer elektrischen Spannung im mittleren Spannungsbereich als kapazitiv wirkende Elektroden beaufschlagbar sind.

Durch Ansteuerung der Außenelektroden 43, 44 sowie der Zusatzelektrode 47 und Gegenelektrode 48 läßt sich bei dem Piezoplättchen 37 eine Biegung in Längsrichtung um die Querachse sowie eine Kippung um die Arme 40, 41 erzielen.

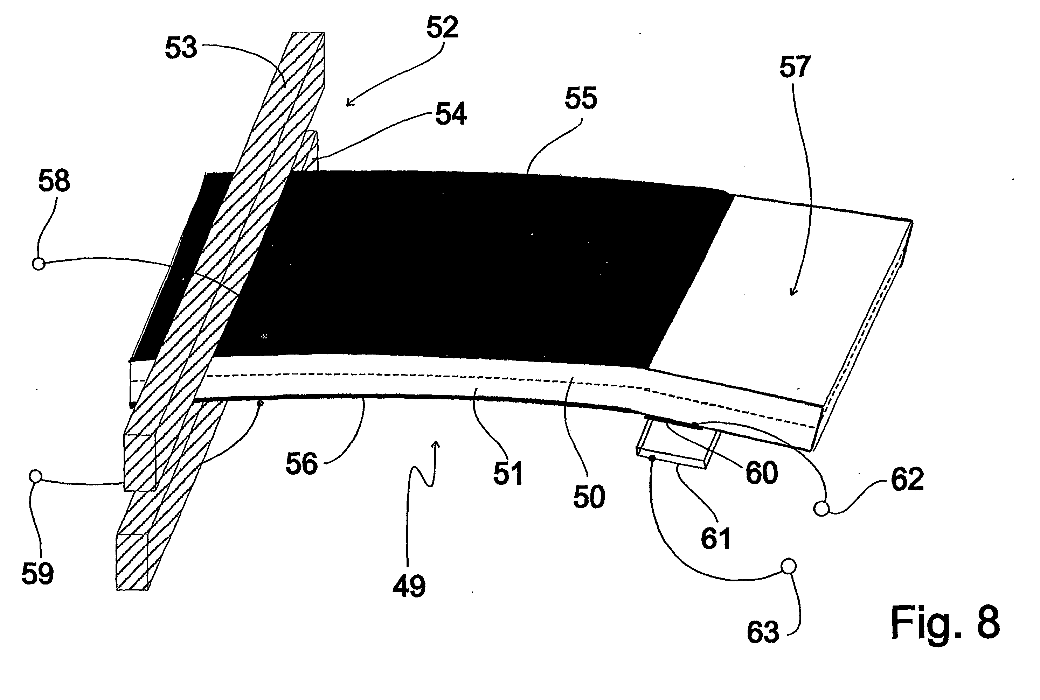

Fig. 8 zeigt in einer perspektivischen Ansicht ein sechstes nicht innerhalb des beanspruchten Schutzumfang liegendes Ausführungsbeispiel für eine zweidimensionale Ablenkung eines Strahls mit einem flachen, einen gedrehten Y₂-Schnitt aufweisenden kristallinen Piezoplättchen 49 mit rechteckiger Grundfläche, das zwei Piezoschichten 50, 51 aufweist. Die Z₂-Achse des kartesischen Koordinatensystems des Piezokristalls ist dabei mit einem Winkel von etwa 40 Grad bis etwa 60 Grad zu der Längsseite des Piezoplättchens 49 ausgerichtet. Die spontanen Polarisationen der Piezoschichten 50, 51 sind bei dem Piezoplättchen 49 des sechsten Ausführungsbeispiels einander entgegengerichtet und beispielsweise durch Erhitzung zur lokalen Domäninversion hergestellt. Das Piezoplättchen 49 ist mit einer ersten schmalen Endseite in eine Haltereinheit 52 mit zwei Halterstegen 53, 54 eingespannt.

Jede Piezoschicht 50, 51 des Piezoplättchens 49 gemäß dem sechsten Ausführungsbeispiel ist ein ihrer nach außen weisenden Flachseite mit einer Außenelektrode 55, 56 als Piezoelektrode belegt. Jede Außenelektrode 55, 56 erstreckt sich von der ersten schmalen Endseite in Richtung der gegenüberliegenden zweiten schmalen Endseite, wobei ein Endabschnitt 57 der zweiten schmalen Endseite frei von Außenelektroden 55, 56 verbleibt.

Jede Außenelektrode 55, 56 ist elektrisch mit einem zugeordneten Außenelektrodenanschluß 58, 59 verbunden. Durch Anlegen einer Spannung zwischen die Außenelektrodenanschlüsse 58, 59 im Hochspannungsbereich läßt sich das Piezoplättchen 49 im Bereich der Außenelektroden 55, 56 zu einer Torsion um die Längsachse in Querrichtung ansteuern, so dass der Endabschnitt 57 parallel zu der Haltereinheit 52 verkippbar und ein den Endabschnitt 57 beaufschlagender Strahl in eine Richtung ablenkbar ist.

Weiterhin ist auf einer Flachseite des Endabschnittes 57 eine Zusatzelektrode 60 aufgebracht, die zusammen mit einer in einem Abstand gegenüberliegenden Gegenelektrode 61 ein kapazitiv wirkendes Elektrodenpaar bildet. Die Zusatzelektrode 60 ist elektrisch mit Zusatzelektrodenanschluß 62 verbunden, während die Gegenelektrode 61 an einen Gegenelektrodenanschluß 63 angeschlossen ist. Bei Ansteuerung der Zusatzelektrode 60 und der Gegenelektrode 61 mit einer Spannung im Niederspannungsbereich wird das Piezoplättchen 49 in Längsrichtung um die Querachse verbogen. Bei Überlagerung der mit den Außenelektroden 55, 56 induzierbaren Verkippung mit der durch die Zusatzelektrode 60 und die Gegenelektrode 61 generierbaren Verbiegung ergibt sich eine zweidimensionale Ablenkung eines den Endabschnitt 57 beaufschlagenden Strahls.

Bei einem nicht dargestellten Ausführungsbeispiel sind zum Erzielen einer zweidimensionalen Ablenkung zwei erfindungsgemäße Vorrichtungen beispielsweise gemäß einem der Ausführungsbeispiele nach Fig. 1 bis Fig. 7 so zueinander angeordnet, dass die Biegerichtungen rechtwinklig zueinander ausgerichtet sind.

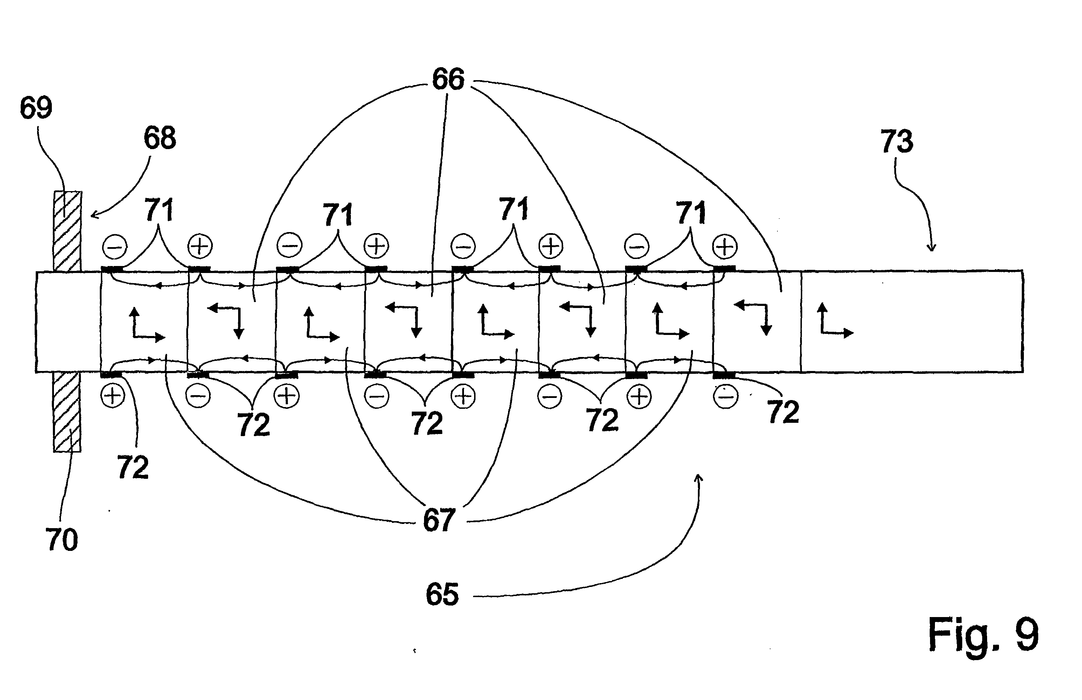

Fig. 9 zeigt in einer Seitenansicht ein siebtes Ausführungsbeispiel der Erfindung. Das siebte Ausführungsbeispiel gemäß Fig. 9 verfügt über ein Piezoplättchen 65, das aus einem Z₁-Schnitt-Kristall gefertigt ist. Das Piezoplättchen 65 ist mit einer Anzahl von sich über die gesamte Dicke erstreckenden, streifenartigen ersten Domänen 66 und zweiten Domänen 67 als Ausrichtbereiche mit jeweils gleicher Ausrichtung der piezoelektrisch wirksamen Achsen ausgebildet. Bei dem Piezoplättchen 65 sind die Y₁-Achsen der Domänen 66, 67 parallel zu der Längsseite ausgerichtet, wobei durch Domäneninversion die Z₁-Achsen der ersten Domänen 66 entgegengesetzt zu den Z₁-Achsen der zweiten Domänen 67 ausgerichtet worden sind. Dadurch sind auch die Y₁-Achsen der Domänen 66, 67 entgegengesetzt zueinander ausgerichtet.

Das Piezoplättchen 65 ist an einer ersten schmalen Endseite in eine Haltereinheit 68 mit zwei Halterstegen 69, 70 eingespannt.

Entlang der Randbereiche einer Anzahl von Domänen 66, 67 sind als Piezoelektroden im Vergleich zu der Breite der Domänen 66, 67 schmale streifenartige Streifenelektroden 71, 72 auf beide Flachseiten des Piezoplättchens 65 aufgebracht, wobei ein Endabschnitt 73 frei von Streifenelektroden 71, 72 verbleibt. Die nebeneinander angeordneten Streifenelektroden 71, 72 auf einer Flachseite sind mit Spannungen alternierender Polarität im mittleren Spannungsbereich beaufschlagbar, wobei die auf verschiedenen Flachseiten einander gegenüberliegenden Streifenelektroden 71, 72 ebenfalls mit Spannungen alternierender Polarität beaufschlagbar sind. Dadurch ergibt sich in Abhängigkeit der Größe der angelegten Spannungen im Bereich der Streifenelektroden 71, 72 eine Biegung des Piezoplättchens 65 in Längsrichtung um die Querachse, während der von Streifenelektroden 71, 72 freie Endabschnitt 73 im wesentlichen plan verbleibt.

## Patentansprüche

1. Piezoplättchen (1; 14; 37; 49; 65) zur Ablenkung von optischen Strahlen (25, 46), bestehend aus piezoelektrischen Bereichen (2, 3; 15, 16; 38, 39; 50, 51; 66, 67), mit an einander gegenüberliegenden aussenseitigen Oberflächen der Bereiche (2, 3; 15, 16; 38, 39; 50, 51; 66, 67) des Piezoplättchens aufgebrachten Aussenelektroden (7, 8, 9; 20, 21; 43, 44; 55, 56; 71, 72) zur Ansteuerung der Deformation des Piezoplättchens (1; 14; 37; 49; 65) senkrecht zu besagten Oberflächen,
**dadurch gekennzeichnet, dass** besagte aussenseitige Oberflächen der piezoelektrischen Bereiche (2, 3; 15,16; 38, 39 ; 50, 51; 66, 67) des Piezoplättchens symmetrisch zu einer parallel zu den aussenseitigen Oberflächen verlaufenden Mittelebene bis zu der Endseite des Piezoplättchens (1; 14; 37; 49; 65) durchgehen und daß in einem dieser Endseite benachbartem Endabschnitt (10; 22; 57; 73) des Piezoplättchens beide aussenliegenden Oberflächen frei von Aussenelektroden (7, 8, 9; 20, 21; 43, 44; 55, 56; 71, 72) sind, wodurch das Piezoplättchen in besagtem Endabschnitt (10; 22; 57; 73) nicht deformiert wird, sodass eine die Wellenfront der optischen Strahlen (25, 46) im wesentlichen ungestört belassende Ablenkung erreicht wird.

2. Piezoplättchen nach Anspruch 1, wobei das Piezoplättchen (65) als piezoelektrische Bereiche parallele Streifen von sich über die Dicke des Piezoplättchens (65) erstreckenden Ausrichtbereiche (66, 67) aufweist, in denen die spontane Polarisation aneinandergrenzender Ausrichtbereiche (66, 67) paarweise gegengerichtet ist, und dass die Außenelektroden als an Randseiten der Ausrichtbereiche (66, 67) verlaufende streifenartige Elektroden (71, 72) ausgebildet sind.

3. Piezoplättchen nach Anspruch 1, wobei das Piezoplättchen (1; 14; 37; 49) als piezoelektrische Bereiche zwei Piezoschichten (2, 3; 15, 16; 38, 39; 50, 51) aufweist, die auf ihrer äußeren Flachseite jeweils mit einer flächigen Außenelektrode (7, 8; 20, 21; 43, 44; 55, 56) belegt sind.

4. Piezoplättchen nach Anspruch 3, wobei die Piezoschichten (2, 3) eine gleichgerichtete spontane Polarisation rechtwinklig zu der Ebene der Piezoschichten (2, 3) aufweisen und dass zwischen den Piezoschichten (2, 3) eine mittlere flächige Piezoelektrode (9) vorhanden ist.

5. Piezoplättchen nach Anspruch 3, wobei die Piezoschichten (15, 16; 38, 39; 50, 51) eine gegengerichtete spontane Polarisation jeweils in der Ebene der Piezoschichten (15, 16; 38, 39; 50, 51) aufweisen.

6. Piezoplättchen nach einem der Ansprüche 1 bis 5, wobei auf dem von Außenelektroden (7, 8; 20, 21; 43, 44; 55, 56; 71, 72) freien Endabschnitt (10; 22; 57; 73) eine hochreflektive Beschichtung aufgebracht ist.

7. Piezoplättchen nach Anspruch 5, wobei ein Einkoppelabschnitt (34) frei von Außenelektroden (20, 21) ist und der sich zwischen dem Endabschnitt (22) und dem Einkoppelabschnitt (34) erstreckende Mittelabschnitt mit einer hochreflektiven Beschichtung versehen ist.

## Claims

1. Piezoplate (1; 14; 37; 49; 65) for deflecting optical beams (25, 46), comprising piezoelectric regions (2, 3; 15, 16; 38, 39; 50, 51; 66, 67), with external electrodes (7, 8, 9; 20, 21; 43, 44; 55, 56; 71, 72) applied to mutually opposed external surfaces of the regions (2, 3; 15, 16; 38, 39; 50, 51; 66, 67) of the piezoplate for controlling the deformation of the piezoplate (1; 14; 37; 49; 65) perpendicular to said surfaces, **characterised in that** said external surfaces of the piezoelectric regions (2, 3; 15, 16; 38, 39; 50, 51; 66, 67) of the piezoplate extend symmetrically to a central plane running parallel to the external surfaces as far as the end side of the piezoplate (1; 14; 37; 49; 65) and that in an end section (10; 22; 57; 73) of the piezoplate adjoining this end side, both the external surfaces are free from external electrodes (7, 8, 9; 20, 21; 43, 44; 55, 56; 71, 72), whereby the piezoplate is not deformed in said end section (10; 22; 57; 73), so that a deflection which leaves the wavefront of the optical beams (25, 46) substantially undisturbed is achieved.

2. Piezoplate according to claim 1, whereby, as piezoelectric regions, the piezoplate (65) has parallel strips of alignment regions (66, 67) extending over the thickness of the piezoplate (65), in which the spontaneous polarisation of mutually adjoining alignment regions (66, 67) is counter-oriented in paired fashion, and that the external electrodes are designed as strip-like electrodes (71, 72) running on side edges of the alignment regions (66, 67).

3. Piezoplate according to claim 1, whereby, as piezoelectric regions, the piezoplate (1; 14; 37; 49) has two piezoelectric layers (2, 3; 15, 16; 38, 39; 50, 51), each of which is equipped on its outer flat side with a flat external electrode (7, 8; 20, 21; 43, 44; 55, 56).

4. Piezoplate according to claim 3, whereby the piezoelectric layers (2, 3) have an equally oriented spontaneous polarisation perpendicular to the plane of the piezoelectric layers (2, 3) and that between the piezoelectric layers (2, 3), a central flat piezoelectrode (9) is present.

5. Piezoplate according to claim 3, whereby the piezoelectric layers (15, 16; 38, 39; 50, 51) each have a counter-oriented spontaneous polarisation in the plane of the piezoelectric layers (15, 16; 38, 39; 50, 51).

6. Piezoplate according to one of the claims 1 to 5, whereby on the end section (10; 22; 57; 73) free of the external electrodes (7, 8; 20, 21; 43, 44; 55, 56; 71, 72), a highly reflective coating is applied.

7. Piezoplate according to claim 5, whereby a coupling-in section (34) is free from external electrodes (20, 21) and a middle section extending between the end section (22) and the coupling-in section (34) is provided with a highly reflective coating.

## Revendications

1. Plaque piézoélectrique (1 ;14 ; 37 ; 49 ; 65) pour incliner des rayons optiques (25, 46), consistant en des zones piézoélectriques (2, 3 ; 15, 16 ; 38, 39 ; 50, 51 ; 66, 67) dotés d'électrodes extérieures (7, 8, 9 ; 20, 21 ; 43, 44 ; 55, 56 ; 71, 72), disposées au niveau de surfaces extérieures opposées les unes aux autres, de zones (2, 3 ; 15, 16 ; 38, 39 ; 50, 51 ; 66, 67) de la plaque piézoélectrique pour commander la déformation de la plaque piézoélectrique (1 ; 14 ; 37 ; 49 ; 65) perpendiculairement auxdites surfaces, **caractérisée en ce que** lesdites surfaces extérieures des zones piézoélectriques (2, 3 ; 15,16 ; 38, 39 ; 50, 51 ; 66, 67) de la plaque piézoélectrique s'étendent symétriquement par rapport à un plan central s'étendant perpendiculairement aux surfaces extérieures, jusqu'à l'extrémité terminale de la plaque piézoélectrique (1 ; 14 ; 37 ; 49 ; 65) et **en ce que** dans un de ces segments terminaux (10 ; 22 ; 57 ; 73) de la plaque piézoélectrique jouxtant cette face terminale, les deux surfaces extérieures sont indépendantes des électrodes extérieures (7, 8, 9 ; 20, 21 ; 43, 44 ; 55, 56 ; 71, 72), la plaque piézoélectrique n'étant pas déformée dans ledit segment terminal (10 ; 22 ; 57 ; 73), de manière à obtenir une inclinaison laissant pour l'essentiel inchangé le front d'onde des rayons optiques (25, 46).

2. Plaque piézoélectrique selon la revendication 1, dans laquelle la plaque piézoélectrique (65) présente comme zones piézoélectriques des bandes parallèles de zones alignées (66, 67) s'étendant au-dessus de l'épaisseur de la plaque piézoélectrique (65), lesdites zones alignées présentant une polarisation spontanée des zones alignées (66, 67) se jouxtant qui est opposée par paire dans leur direction et en ce que les électrodes extérieures sont configurées comme des électrodes (71, 72) en forme de bande s'étendant au niveau des faces extérieures des zones alignées (66, 67).

3. Plaque piézoélectrique selon la revendication 1, dans laquelle la plaque piézoélectrique (1 ; 14 ; 37 ; 49) présente comme zones piézoélectriques deux couches piézoélectriques (2, 3 ; 15, 16 ; 38, 39 ; 50, 51), lesquelles sont dotées respectivement d'une électrode extérieure (7, 8 ; 20, 21 ; 43, 44 ; 55, 56) plane sur leur surface plane extérieure.

4. Plaque piézoélectrique selon la revendication 3, dans laquelle les couches piézoélectriques (2, 3) présentent une polarisation spontanée de même direction perpendiculaire au plan des couches piézoélectriques (2, 3) et en ce qu'une électrode piézoélectrique (9) plane centrale est disposée entre les couches piézoélectriques (2, 3).

5. Plaque piézoélectrique selon la revendication 3, dans laquelle les couches piézoélectriques (15, 16 ; 38, 39 ; 50, 51) présentent respectivement une polarisation spontanée de direction opposée dans le plan des couches piézoélectriques (15, 16 ; 38, 39 ; 50, 51).

6. Plaque piézoélectrique selon l'une quelconque des revendications 1 à 5, dans laquelle un revêtement hautement réfléchissant est disposé sur l'extrémité terminale (10 ; 22 ; 57 ; 73) libre des électrodes extérieures (7, 8 ; 20, 21 ; 43, 44 ; 55, 56 ; 71, 72).

7. Plaque piézoélectrique selon la revendication 5, dans laquelle un segment de couplage (34) est indépendant de l'électrode extérieure (20, 21) et en ce qu'un segment central doté d'un revêtement hautement réfléchissant et s'étendant entre le segment terminal (22) et le segment de couplage (34) est prévu.
